# EUROPÄISCHE PATENTSCHRIFT

(11) **EP 2 208 216 B1**
(45) Veröffentlichungstag und Bekanntmachung des Hinweises auf die Patenterteilung: **06.11.2013**
(21) Anmeldenummer: 08717297.9
(22) Anmeldetag: 29.02.2008
(51) Int. Cl.: H01J 37/32, C23C 14/32, C23C 14/00, C23C 14/08

(54) **Verfahren zum Betreiben einer Arcquelle und Verfahren zum Abscheiden elektrisch isolierender Schichten**
Method of operating an arc source and method for depositing electrically insulating layers
Procédé de fonctionnement d'une source d'arc et procédé de séparation des couches électriquement isolantes

(30) Priorität: 08.11.2007 US 937071
(43) Veröffentlichungstag der Anmeldung: 21.07.2010
(73) Patentinhaber: Oerlikon Trading AG, Trübbach, 9477 Trübbach (CH)
(72) Erfinder: RAMM, Jürgen, CH-7304 Maienfeld (CH); WOHLRAB, Christian, A-6800 Feldkirch (AT)
(74) Vertreter: Troesch, Jacques J.
(86) Internationale Anmeldenummer: PCT/EP2008/052521
(87) Internationale Veröffentlichungsnummer: WO 2009/059807

(56) Entgegenhaltungen:
- EP-A- 0 666 335
- EP-A- 0 729 173
- WO-A-2006/099754
- WO-A-2006/099758
- JP-A- 1 042 574
- US-A1- 2005 233 551

## Beschreibung

### Technisches Gebiet

Die Erfindung betrifft ein Verfahren zum Betreiben einer Arcquelle gemäss dem Oberbegriff des Anspruchs 1.

### Stand der Technik

Aus dem Stand der Technik sind unterschiedliche Verfahren bekannt Arcquellen, auch Arcverdampferquellen oder Funkenverdampfer genannt, mittels einer Kombination aus einer DC-Stromversorgung und einer Pulsstromversorgung zu betreiben.

Beispielsweise wird in der EP 0 666 335 B1 vorgeschlagen, zum Verdampfen gut leitender Materialien, einem mit Gleichstrom betriebenen Arcverdampfer einen pulsierenden Strom zu überlagern. Hierbei werden Pulsströme bis zu 5000 A erzielt, welche bei relativ tiefen Pulsfrequenzen im Bereich von 100 Hz bis höchstens 50kHz mit Kondensatorentladungen erzeugt werden. Damit soll u.a. beim Verdampfen von rein metallischen Targets die Dropletbildung wesentlich reduziert werden. Zur Erzeugung der unterschiedlich herstellbaren Pulsformen des Pulsstroms werden einzelne Kondensatorentladungen verwendet. Dabei kommt es beispielsweise beim Herstellen eines rechteckigen Strompulsmusters zu einer sehr kurzzeitigen Erhöhung der Entladespannung, die aber nicht konstant gehalten werden kann, sondern wieder zusammenfällt, da auf Grund der niedrigen Plasmaimpedanz in der Funkenentladung sofort der Funkenstrom ansteigt, was einen Abfall der Kondensatorentladespannung und damit der Funkenentladespannung zur Folge hat. Trotz des vermuteten positiven Effekts der kurzfristigen Spannungsspitzen gelingt es nicht eine höhere Funkenentladespannung über längere Zeiträume aufrecht zu erhalten.

Demgegenüber sind aus den Dokumenten WO 2008/043606 bzw. US 2008/090099 desselben Anmelders Verfahren bekannt, die zusätzlich zu dem in EP 0 666 335 B1 erwähnten Verfahren gepulste Funkenströme zum Verdampfen von Metallen in Reaktivgasatmosphäre beschreiben, die zur Herstellung isolierender, insbesondere oxidischer Schichten benutzt werden. In diesen Verfahren wird sowohl die vorteilhafte Wirkung des Pulsens auf die Spritzerreduktion beschrieben wie auch auf den Betrieb der Funkentargets in Reaktivgasatmosphäre, im Besonderen in Sauerstoff eingegangen. Weiters wird in diesen Anmeldungen erstmals auch auf die Wichtigkeit der Steilheit des der Funkenentladespannung überlagerten Spannungspulses eingegangen. Die vorliegende Anmeldung baut auf dieser Erfindung auf.

### Darstellung der Erfindung

Der Erfindung liegt die Aufgabe zu Grunde, ein Verfahren zur Verfügung zu stellen, bei welchem die oben erwähnten Nachteile des Standes der Technik vermieden und die Vorteile der hohen Ionisierung einer Funkenentladung mit dem Vorteil einer erhöhten Entladespannung verbunden werden können, ohne dabei die Funkenkathode, insbesondere die Oberfläche der Funkenkathode übermässig thermisch zu belasten. Diese Aufgabe wird durch die erfindungsgemässen Merkmale im kennzeichnenden Teil des Anspruchs 1 gelöst.

Dabei wird eine elektrische Funkenentladung auf einer Oberfläche eines Targets gezündet bzw. betrieben und die Funkenentladung gleichzeitig mit einem Gleichstrom und einer verhältnismässig niedrigen Gleichspannung einer Stromquelle betrieben. Gleichzeitig wird ein durch ein periodisch angelegtes Spannungssignal erzeugter Pulsstrom eingespeist, wobei die Signalform des Spannungssignals im Wesentlichen frei wählbare ist.

Prinzipiell gibt es verschiedene Möglichkeiten, den Funkenstrom zu pulsen und auf diese Art und Weise die Funkenentladespannung heraufzusetzen.

Das Verwenden einer gepulsten Stromversorgung, die den Strom für die Funkenentladung liefert, wäre vom Ansatz her die einfachste. Es hat sich aber gezeigt, dass mit üblichen Generatoren des Standes der Technik zum Schalten/Pulsen hoher Ströme dieser Ansatz nicht oder nur zu einer ungenügenden und nicht zumindest für die Dauer des anliegenden Signals konstanten Erhöhung der Funkenentladespannung führt. Die Spannungsanstiege sind nicht schnell genug und steilere Flanken lassen sich auch nicht über höhere Frequenzen realisieren, da es schwierig oder unmöglich ist, diese bei hohen Funkenströmen um die 100 A oder mehr zu erzielen. Somit resultiert das Anlegen eines solchen Pulssignals lediglich in einer kurzen Spannungsspitze mit geringer Amplitude, die durch einen der eingebrachten Leistung entsprechenden Stromanstieg und die durch die rasche Erhöhung des Ladungsträgerangebots verringerte Plasmaimpedanz ausgeglichen wird. Auch die Kombination von zwei separaten Stromversorgungen, von der die eine gepulst betrieben wird, erreicht keine wesentlichen Verbesserungen.

Gemäss vorliegender Erfindung wird eine Arcquelle mit einem Verfahren nach Anspruch 1 betrieben. Dabei kann der Funkenstrom durch Parallelschaltung einer gepulsten Spannungsquelle, die hohe Leistungen im Puls liefern kann, betrieben werden, um die gewünschte Signalform des Spannungssignals sicherzustellen. Wie unten näher beschrieben, kann dies beispielsweise durch eine entsprechend rasche zeitliche Abfolge mehrerer Kondensatorentladungen oder durch Verwendung einer speziell ausgelegten Spannungsversorgung bewirkt werden.

Die durch die Erfindung erreichten Vorteile sind unter anderem darin zu sehen, dass durch eine bessere Beherrschung bzw. Einstellbarkeit des Strom-/Spannungsbereichs der Funkenentladung für unterschiedliche Targetmaterialien und Prozessbedingungen, Arbeitsbereiche eingestellt werden können, bei denen Schichten mit einer von der Funkenverdampfung bekannten hohen Beschichtungsrate abgeschieden werden können, die eine in Bezug auf die Spritzerbildung auf der Oberfläche des Beschichtungsgutes deutlich verbesserte Qualität aufweisen.

Dies gilt nicht nur für die Abscheidung von metallischen Schichten, sondern insbesondere auch für die Synthese von Schichten in reaktiven Prozessen bei gleichzeitig hohen Depositionsraten. Beispielsweise kann dabei der zu einem noch grösseren Anteil als bei herkömmlichen Funkenentladungsprozessen ionisierte Dampf des Targets mit dem ebenfalls zumindest teilweise ionisiertem bzw. dissoziierten Reaktivgas im Plasma bzw. auf der Oberfläche des zu beschichtenden Werkstücks zu einer entsprechenden schichtbildenden Verbindung reagieren. Neben der Vielzahl von bekannten Hartstoffverbindungen wie beispielsweise Nitride, Karbide, Karbonitride, Boride, Siliziumverbindungen und andere Verbindungen einzelner oder mehrerer Übergangsmetalle der IV., V. und VI. Gruppe des Periodensystems der Elemente (nach IUPAC-Standard 2005) sowie des Aluminiums, sei hier besonders die Möglichkeit hervorgehoben mit diesem Verfahren auch oxidische oder andere isolierende Schichten herzustellen. Besonders vorteilhaft ist dieses gepulste Verfahren bei der Funkenverdampfung von Kohlenstoff. In diesem Material lässt sich der kathodische Funken mit einer reinen DC Stromversorgung schlecht ablenken. Das Überlagern mit Spannungspulsen scheint das Elektronenemissionsverhalten derart zu beeinflussen, dass das "Festfressen" des Funkenfusspunktes vermieden wird und wasserstofffreie, harte Kohlenstoffschichten wie beispielsweise ta-C abgeschieden werden können. Unter "Festfressen" wird hier das längere Verweilen des Funkenfusspunktes auf einem sehr kleinen Bereich der Targetoberfläche verstanden, was insbesondere bei Kohlenstofftargets häufig mit einer Beschädigung der Oberfläche, vermehrter Spritzerbildung sowie einer Abnahme der Beschichtungsrate einhergeht.

Für die Herstellung von Mischkristallen in Korundstruktur eignen sich Arcverfahren ohne, bzw. mit speziell ausgelegtem kleinem senkrechten Magnetfeld und pulsüberlagerte Arcverfahren, sowie allgemein Verfahren wie beispielsweise Arc- oder Sputterverfahren, bei denen an die Materialquellen, wie Arcverdampfer bzw. Sputterquellen, Hochstromimpulse angelegt, bzw. dem DC-Grundbetrieb überlagert werden. Damit ist ein Betrieb im vergifteten Zustand, bzw. eine Legierungsbildung am Target möglich, sofern gewisse unten näher erläuterte Randbedingungen eingehalten werden.

Bei den Pulsquellenverfahren zur Herstellung von insbesondere thermisch stabilen Mischkristallschichten von Mehrfachoxiden im Kristallgitter des Korundtyps wird zumindest eine Arcquelle gleichzeitig mit einem Gleichstrom als auch mit einem Puls- bzw. Wechselstrom gespeist. Dabei wird mit einer als Legierungstarget ausgeführten ersten Elektrode einer Arc- oder einer Sputterquelle sowie mit einer zweiten Elektrode eine Schicht auf das Werkstück abgeschieden, wobei die Quelle gleichzeitig mit einem Gleichstrom bzw. Gleichspannung als auch mit einem Puls-oder Wechselstrom bzw. einer Puls- oder Wechselspannung gespiesen wird. Das Legierungstarget entspricht dabei im Wesentlichen der Zusammensetzung der Mischkristallschicht. Die bevorzugte Pulsfrequenz liegt dabei in einem Bereich von 1khz bis 200kHz, wobei die Pulsstromversorgung auch mit einem unterschiedlichen Pulsbreitenverhältnis, bzw. mit Pulspausen, betrieben werden kann.

Die zweite Elektrode kann dabei von der Arcquelle getrennt oder als Anode der Arcquelle angeordnete sein, wobei die erste und die zweite Elektroden mit einer einzelnen Pulsstromversorgung verbunden, betrieben werden. Wird die zweite Elektrode nicht als Anode der Arcquelle betrieben, kann die Arcquelle über die Pulsstromversorgung mit einer der folgenden Materialquelle verbunden bzw. betrieben werden:
- Einer weiteren Arcverdampferquelle, die ebenfalls mit einer DC-Stromversorgung verbunden ist;
- Einer Kathode einer Sputterquelle, insbesondere einer Magnetronquelle, die ebenfalls mit einer Stromversorgung, insbesondere mit einer DC-Stromversorgung verbunden ist;
- Einem Verdampfungstiegel der gleichzeitig als Anode eines Niedervoltbogenverdampfers betrieben wird.

Die DC-Stromversorgung erfolgt dabei mit einem Grundstrom so, dass die Plasmaentladung zumindest an den Arcverdampferquellen, bevorzugt jedoch an allen Quellen im wesentlichen unterbrechungsfrei aufrechterhalten wird. Vorteilhafterweise wird dabei jeweils die DC-Stromversorgung und die Pulsstromversorgung mit einem elektrischen Entkopplungsfilter entkoppelt das vorzugsweise mindestens eine Sperrdiode enthält. Die Beschichtung kann dabei bei Temperaturen kleiner 650°C , bevorzugt kleiner 550°C erfolgen.

Alternativ zur Funkenverdampfung kann die Schichtbildung im Wesentlichen auch nur durch die Zerlegung von gasförmigen Precursern erfolgen, sofern die optische Verbindung zwischen Werkstück und Funkenquelle beispielsweise durch Blenden oder andere bauliche Massnahmen unterbrochen wird. Beispielhaft seien hier unterschiedliche DLC- oder Diamant Schichten wie unter anderem in VDI 2840, Tabelle 1, beschrieben, Siliziumnitrid, Bornitrid und ähnliche Systeme genannt. Viele dieser Schichten können auch in kombinierten Prozessen, in denen ein Teil des schichtbildenden Materials aus der Gasphase und ein anderer Teil aus dem Plasma einer Sputter- oder Funkenkathode kommt, abgeschieden werden.

Weiters ist es mit einem solchen Verfahren möglich, durch Einstellen der Höhe und Steilheit der Flanken des periodisch angelegten Spannungssignals bzw. der das Spannungssignal bildenden Nadelimpulse die Elektronenemission der Funkenentladung zu kontrollieren. Diese wird umso stärker, je höher das Spannungssignal bzw. der Nadelimpuls, bzw. je steiler die jeweils entsprechende Flanke des Spannungsanstiegs gewählt wird.

Wird eine elektrische Funkenentladung mit einem Gleichstrom und einem durch ein periodisch angelegtes Spannungssignal erzeugten Pulsstrom betrieben, ist es vorteilhaft, die Frequenz des Spannungssignals zwischen 1 Hz und 200 kHz , bevorzugt zwischen 10 Hz und 50 kHz zu wählen. Die Signalform des Spannungssignals kann dabei beispielsweise ein Sägezahn, ein Vieleck, ein Trapez sein, wobei eine rechteckige Form für viele Anwendungen auf Grund des damit gegebenen besonders schnellen Spannungsanstiegs auf die volle Amplitudenhöhe und des Verweilens auf diesem Spannungsniveau PV über die gesamte Pulsdauer Tp bevorzugt ist.

Das Spannungssignal bzw. der Spannungsgenerator kann dabei auch mit lückenden Pulsen, d.h. mit einer Pulslänge die weniger lang ist als die Hälfte der Periodendauer der Betriebsfrequenz, betrieben werden.

Auf Grund des hohen Ionisierungsgrades des durch die Funkenentladung erzeugten Plasmas und der damit in ausreichender Anzahl vorhandenen Ladungsträger steigt auch der Strom sofort oder nur mit einer Verzögerung im Bereich weniger Mikrosekunden. Da jedoch der Ladungstransport einerseits im Plasma sowohl durch Elektronen als auch durch Ionen erfolgt und letztere eine bestimmte Trägheit aufweisen und andererseits auch weitere Widerstände, wie z.B. Kabelimpedanzen im Funkenstromkreis eine Rolle spielen, kann der Strom nicht sofort im selben Ausmass dem gepulsten Spannungssignal folgen. Dieser Effekt kann bei vorliegendem Verfahren ausgenutzt werden, indem Spannungssignale mit sehr hoher Amplitude angelegt werden, die ohne die zeitliche Begrenzung der Pulslänge bzw. der Nadelsignale wie unten näher beschrieben, rasch zu einem Zusammenbruch der Spannung, einer Überlast des Spannungsgenerators, der Ausbildung von schädlichen elektrischen Überschlägen, der Beschädigung der Targetoberfläche, einem Prozessunterbruch oder ähnlichen unerwünschten Erscheinungen führen würden. Alternativ oder als zusätzliche Sicherheitsmassnahme kann zur Begrenzung des Stromanstiegs durch die Puls- bzw. Nadelimpulsfrequenz ein schädlicher Stromanstieg auch durch Abschalten des Spannungssignals bei Überschreitung einer detektierten Stromschwelle bewirkt werden. In beiden Fällen können je nach Bedarf und vom Fachmann für den jeweiligen Einsatzfall, beispielsweise durch Einstellung der entsprechenden Zeitkonstanten des Spannungsimpulses, ermittelbar, angepasste Pulspausen beispielsweise durch wie oben erwähnten lückenden Betrieb vorgesehen werden, um den Signalverlauf für Prozesse mit beispielsweise unterschiedlichem Targetmaterial oder unterschiedlicher Prozessgaszusammensetzung zu optimieren.

Vorteilhaft wird dabei die Signalform durch die Resultierende einer Aneinanderreihung von Nadelimpulsen gebildet, die beispielsweise durch eine in zeitlicher Abfolge gesteuerte Entladung einzelner Kondensatoren erzeugt werden. Die Flankensteilheit der Nadelimpulse sollte dabei zumindest 0.5 V/µs, bevorzugt aber zumindest 2 V/µs betragen und bestimmt somit auch die Steilheit des durch die Resultierende gebildeten Spannungssignals. Die Abfolge, bzw. die Dauer der Nadelimpulse kann zwischen 0.1 kHz und 1 MHz, bzw. 10 ms und 1 µs, bevorzugt aber zwischen 1 kHz und 500 kHz, bzw. 1 ms und 2 µs eingestellt werden. Wie schon erwähnt, ist es von besonderem Vorteil, die Nadelpulse so zu wählen, dass die Resultierende einen quasi-stationären Spannungsverlauf über die Pulsdauer Tp aufweist, also etwa rechteckige Form besitzt, damit über die Pulsdauer die gewünschten Emissionsvorgänge an der Kathode stabil gehalten werden können.

Die absolute Amplitudenhöhe des Nadelimpulses, bzw. des Spannungssignals sollte dabei die anliegende Gleichspannung um mindestens 10 Prozent, bevorzugt aber um mindestens 30 Prozent übersteigen, um die gewünschten Effekte der höheren Ionisierung etc. zu erzielen.

Der Vorteil einer solchen Abfolge von Kondensatorentladungen besteht darin, dass sehr hohe Pulsleistungen, beispielsweise einige hundert kW pro Puls, realisiert werden können. Im Vergleich dazu werden die Funkentargets im DC Betrieb mit typischerweise 5 bis 10 kW betrieben. Eine hochfrequente Überlagerung mit diesen Hochleistungspulsen aus nur einer Kondensatorenentladung würde aber zu einer Überlastung der Quelle und/oder an anderen Teilen der Anordnung führen und auch nicht die gewünschte Spannungsstabilität über die Pulsdauer garantieren. Deshalb sind diese hochenergetischen Kondensatorentladungen für Frequenzbereiche bis etwa 10, höchstens jedoch 50 kHz sinnvoll. Die Entladung von Kondensatoren kleinerer Kapazität und deren zeitliches Aneinanderreihen können jedoch, wie dem Fachmann geläufig, auch mit höherer Frequenz erfolgen.

Alternativ können solche Spannungssignale bzw. die entsprechende Abfolge von Nadelimpulsen auch durch eine oder mehrere in Bezug auf Signallänge, Signalfrequenz, Spannungsamplitude, Pulspausen und/oder Signalform frei einstellbare Spannungsversorgungen bereitgestellt werden, sofern diese auf eine Abgabe von gepulsten Spannungssignalen einer hohen Flankensteilheit ausgelegt sind. Eine solche Spannungsversorgung wird beispielsweise in WO 06099759 näher beschrieben. Die entsprechende Anmeldung, insbesondere die Beschreibung der Verwendung einer solchen Spannungsversorgung, dort Vakuumplasmagenerator genannt, von Seite 14, 2. Absatz bis Seite 17 unten, wird daher als integraler Bestandteil der vorliegenden Patentanmeldung erklärt. Mit einem derartigen Generator ist es auch möglich, Flankensteilheiten von 0.1 V/ns bis 1.0 V/ns zu realisieren.

Die Verwendung solcher Spannungsversorgungen empfiehlt sich besonders wenn höhere Pulsfrequenzen, etwa zwischen 10 bis 200 kHz verwendet werden sollen. Dabei ist zu bedenken, dass die Benutzung einer gepulsten Spannungsquelle, bzw. Spannungsversorgung immer ein Kompromiss aus erreichbarer Pulsenergie und möglicher Frequenz ist.

Um die thermische Anregung auf der Targetoberfläche weiter zu erhöhen wurden auch einzelne Versuche mit ungekühlten, bzw. mit geheizten Targets gefahren und unter Sauerstoff von der bald rot glühenden Targetobefläche Material verdampft. Auch die so hergestellten Schichten zeigen ein Gitter vom Korundtyp. Gleichzeitig kann bei solchen Prozessen an Hand des Anstiegs der Entladungsspannung eine Erhöhung der Plasmaimpedanz festgestellt werden, die auf die erhöhte Elektronenemission glühender Oberflächen in Kombination mit erhöhtem Dampfdruck des Targetmaterials zurückzuführen ist und durch das Pulsen des Quellenstroms noch verstärkt wird.

Eine weitere Möglichkeit zur Herstellung erfindungsgemässer Oxidschichten ist das Betreiben einer Hochleistungsentladung mit zumindest einer Quelle. Diese kann beispielsweise durch Betreiben der Pulsstrom- bzw. Pulsspannungsversorgungen mit einer Pulsflankensteilheiten die mindestens im Bereich von 0,02 V/ns bis 2,0 V/ns, vorzugsweise im Bereich von 0,1 V/ns bis 1,0 V/ns liegt erzeugt werden. Dabei werden Ströme von zumindest 20 A, bevorzugt jedoch gleich oder grösser 60A, bei Spannungen zwischen 60 und 800 V, bevorzugt zwischen 100 und 400 V über bzw. zusätzlich zu Spannung und Strom der gleichzeitig betriebenen DC-Entladung angelegt. Diese Spannungsnadelimpulse können beispielsweise durch eine oder mehrere Kondensatorkaskaden erzeugt werden, was neben verschiedenen anderen Vorteilen es auch ermöglicht die Grundstromversorgung zu entlasten. Bevorzugt wird aber der Pulsgenerator zwischen zwei gleichzetig mit DC-betriebenen Arcquellen geschaltet. Überraschenderweise gelingt es durch das Anlegen der Nadelimpulse im Arcverfahren die Spannung an der Quelle über mehrere µs in Abhängigkeit von der Höhe des angelegten Spannungssignals zu erhöhen, wohingegen Pulse mit geringerer Flankensteilheit sich wie zu erwarten lediglich in einer Erhöhung des Quellenstroms auswirken.

Wie erste Versuche gezeigt haben ist es mit solchen Hochstromentladungen auch möglich von Sputterquellen mit Legierungstargets oxidische Mehrfachoxide in Korund-, Eskolait- oder vergleichbaren hexagonalen Kristallstrukturen herzustellen, was vermutlich auf die erhöhte Leistungsdichte an der Oberfläche des Targets und der damit einhergehenden starken Temperaturerhöhung zurückzuführen ist, auch hier könnte die Verwendung ungekühlter oder beheizter Targets wie oben beschrieben vorteilhaft sein. Die Hochleistungsentladung zeigt für solche Prozesse sowohl für das Hochleistungsarcen als auch für das Hochleistungssputtern ähnliche Charakteristika, wie sie der aus dem Townsend-Strom-Spannungs-Diagramm bekannten anormalen Glimmentladung entsprechen.

Grundsätzlich sind unterschiedliche Massnahmen zur Impedanzerhöhung des Plasmas bzw. der Targetoberfläche möglich. Dies kann, wie oben beschrieben durch Überlagerung von Nadelimpulsen, durch Erhitzen der Targetoberfläche oder durch eine Kombination der Massnahmen bewirkt werden. Als Überlagerung wird hier eine Überlagerung der DC-Entladungspannung mit Nadelimpulsen verstanden, wobei eine zeitliche Überlagerung der Nadelimpulse, im Sinne einer Abfolge von Nadelimpulsen, die sich zumindest teilweise überlagern nicht ausgeschlossen ist. Es versteht sich für den Fachmann von selbst, dass zur Erreichung besonders hoher Leistungen auch beispielsweise zwei oder mehrere Kondensatoren gleichzeitig entladen werden können und so quasi einen besonders hohen Nadelimpuls bilden.

### Kurze Beschreibung der Zeichnungen

Im Folgenden wird die Erfindung anhand von Figuren, welche lediglich verschiedene Ausführungsbeispiele der vorliegenden Erfindung darstellen, näher erläutert. Es zeigen
- Fig. 1: Eine Funkenbeschichtungsanlage mit DC- und Pulsstromversorgung;
- Fig. 2: Eine Funkenbeschichtungsanlage mit DC-Stromversorgung und Pulskondensator;
- Fig. 3: einen schematisches Spannungsverlauf;
- Fig. 4: einen schematischen Spannungs/Stromverlauf;
- Fig. 5: einen gemessenen Spannungs/Stromverlauf.

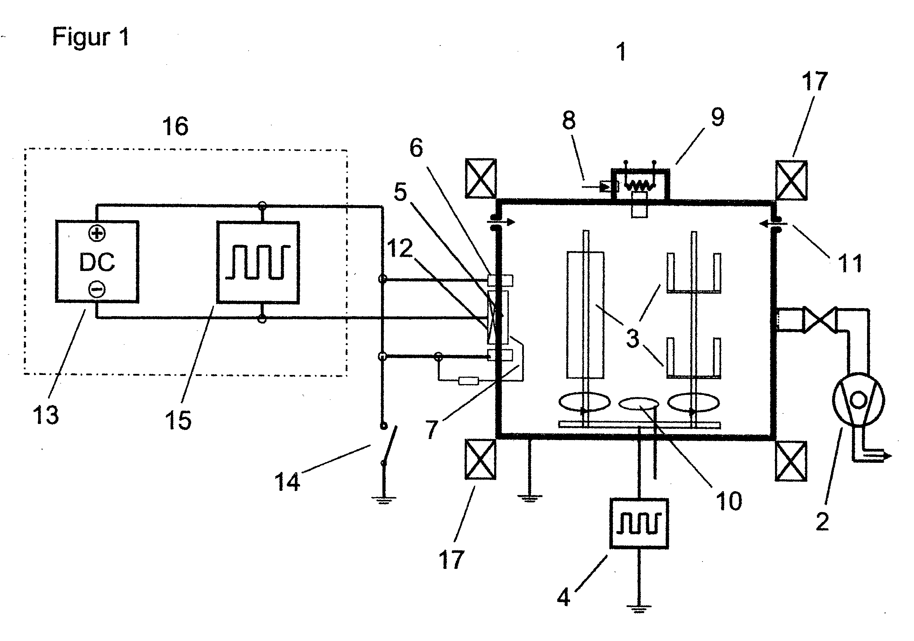

Die in Fig.1 dargestellte Vakuumbehandlungsanlage 1 zeigt eine Anordnung zum Betreiben einer Arcquelle mit einer kombinierte Generatoreinheit 16, die eine DC-Stromversorgung 13 und eine damit parallel geschaltete gepulste Spannungsquelle 15, in diesem Fall eine Spannungsversorgung 15 enthält, um den Gleichstrom mit einem gepulsten Spannungssignal zu überlagern. Diese Beschaltung erlaubt einen stabilen Betrieb einer reaktiven Funkenverdampfung auch für isolierende Schichten, bei denen sich im Zeitverlauf das Innere der Anlage 1, die Hilfsanode 10 und die Substrathalterungen 3 bzw. Substrate mit einer isolierenden Schicht belegen. Die Anlage 1 ist mit einem Pumpstand 2 zum Erstellen des Vakuums, Substrathalterungen 3 zum Aufnehmen und elektrischen Kontaktieren der hier nicht näher dargestellten Werkstücke, sowie einer Biasstromversorgung 4, zum Anlegen einer sogenannten Substratspannung an die Werkstücke ausgerüstet. Letztere kann eine DC-, eine AC- oder eine bi- bzw. unipolare Substratspannungsversorgung sein. Über zumindest einen Prozessgaseinlass 11 kann Inert- bzw. Reaktivgas eingelassen werden, um Prozessdruck und Gaszusammensetzung in der Behandlungskammer zu steuern.

Bestandteile der Arcquelle selbst sind ein Target 5 mit einem Zündfinger 7 sowie eine das Target 5 umfassenden Anode 6. Mit einem Schalter 14 kann zwischen einem floatenden Betrieb der Anode und des positiven Pols der Stromversorgung 13 und einem Betrieb mit definiertem Null- bzw. Massepotential gewählt werden. Weiters kann die Arcquelle auch ein Targetmagnetsystem 12, beispielsweise eine oder mehrere Spulen und/oder ein Permanentmagnetsystem umfassen.

Weitere fakultative Merkmale der Vakuumbehandlungsanlage 1 sind eine zusätzliche Plasmaquelle 9, in diesem Fall eine Quelle zur Erzeugung eines Niedervoltbogens (NVB) mit Heisskathode, mit Inertgaseinlass 8, eine Hilfsanode 10, sowie einer hier nicht näher dargestellten weiteren Stromversorgung zum Betreiben des Niedervoltbogens zwischen Plasmaquelle 9 und Hilfsanode 10, und bei Bedarf Spulen 17 zur magnetischen Bündelung des Niedervoltbogenplasmas.

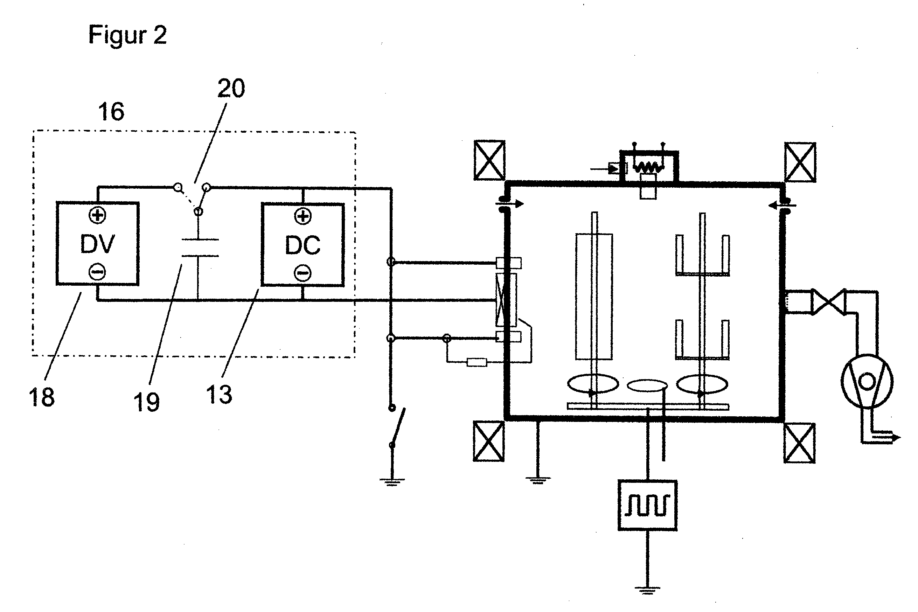

In Figur 2 besteht die gepulste Spannungquelle aus zumindest einer Ladespannungsversorgung 18, zum Laden mehrerer Kondensatoren oder Kondensatorenarrays 19, und entsprechenden Schaltern 20, welche die Kondensatoren 19 zeitlich gesteuert zum Laden an die Ladespannungsversorgung oder zur Erzeugung eines Nadelimpulses an die Arcquelle schalten. Der Einfachheit halber ist in Fig.2 nur ein Kondensator 19 und ein Schalter 20 dargestellt, die eine entsprechende Anordnung von Kondensatoren und Schaltern repräsentieren. Die Ladespannungsversorgung 18 stellt dabei beispielsweise eine konstante Spannung zwischen 100 bis 1000 V zur Verfügung, während die Betriebsspannung der hier ebenfalls in einer Generatoreinheit 16 integrierten DC-Stromversorgung 13 im Bereich der üblichen Betriebsspannungen für Funktenentladungsgeneratoren bei etwa 10 bis etwa 100 V liegt.

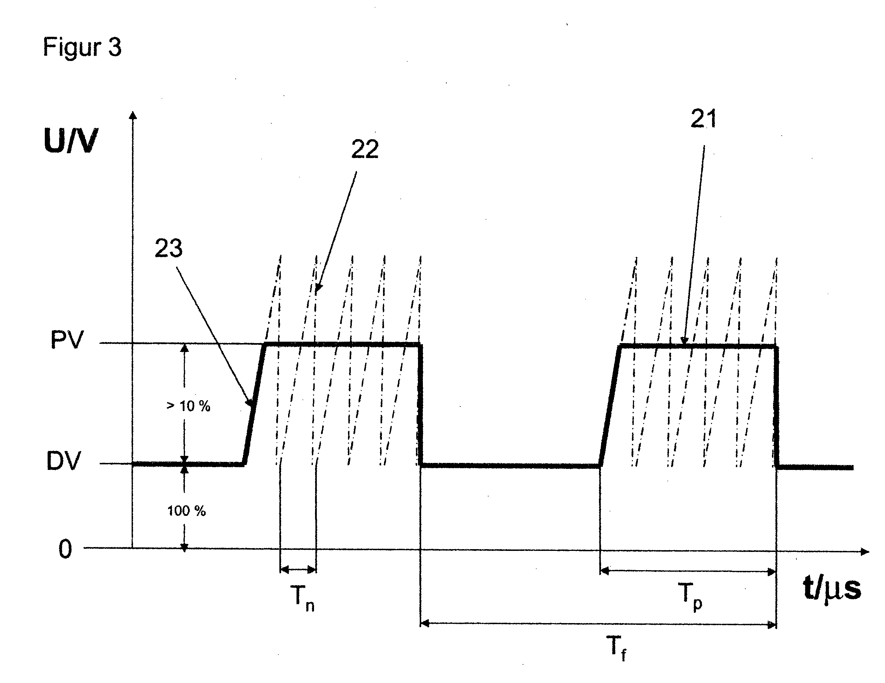

Figur 3 zeigt einen möglichen Spannungsverlauf, der durch eine entsprechende Ansteuerung der Schalter 20 erzeugt werden kann. Dabei wird eine Anzahl von Kondensatorentladungen so aneinandergereiht, dass die Resultierende 21 der durch die Entladungen der Kondensatoren erzeugten Nadelimpulse 22, die Signalform des gepulsten Spannungssignals mit einer Pulsspannung PV erzeugt. Die idealisierte Resultierende 21, die im Wesentlichen der effektiv gemessenen Spannung entspricht, läuft bei gleich hohen Nadelimpulsen in etwa zwei Drittel Höhe der Maximalen Nadelspannung und kann mit einem Ripple überlagert sein, der durch elektrische Impedanzen und durch die Beabstandung der Nadelimpulse begründet ist. Die Nadelimpulse 22 sind hier schematisch als Dreiecke gezeichnet und ohne Lücken. Selbstverständlich können die Nadelimpulse auch abweichende Formen aufweisen und lückend aneinandergereiht werden. Die gepulsten Spannungssignale setzen dabei auf das von der DC-Stromversorung 13 erzeugte Niedervolt-Gleichspannungssignal der Höhe DV auf. Durch die rasche paketweise Aufeinanderfolge der Nadelimpulse 22 der Dauer Tₙ kann die Spannungserhöhung PV-DV über einen längeren Zeitraum Tp, zumindest aber so lange stabil gehalten werden, um ein mittelfrequentes Pulssignal der Dauer T_{f} zu bilden. Die Form des Signals kann dabei durch ein dem Fachmann bekanntes Anlegen unterschiedlich hoher bzw. langer Nadelimpulse, bzw. durch Anpassen der Kondensatorentladungen an die Impedanz der Funkenentladung variiert werden. Bei einem Rechtecksignal kann die ansteigende Flanke 23 der Resultierenden 21 dieselbe Steigung wie die Nadelimpulse ausweisen, sofern die Kapazität des einzelnen Kondensators gross genug gewählt ist. Alternativ können, wie dem Fachmann bekannt, jeweils eine Vielzahl kleinerer Kondensatoren synchron getaktet werden, um ein entsprechendes Spannungssignal zu erzwingen.

T_{f} kann dabei zwischen 5 µs bis zu 1 s, bevorzugt aber zwischen 20 µs und 100 ms eingestellt werden. Dabei ist, wie erwähnt, auch ein lückender Betrieb möglich. Tₙ kann zwischen 1 µs bis 100 ms, bevorzugt zwischen 2 µs bis 1 ms eingestellt werden. Werden extrem kurze Spannungssignale gewünscht, kann das Spannungssignal durch nur einen Nadelimpuls gebildet werden. In diesem Fall kommt es lediglich zur Ausbildung einer Spannungsspitze. Der Vorteil des vorliegenden Verfahrens, die Signalform frei einzustellen, kann aber erst durch eine Mindestabfolge von drei, bevorzugt fünf, insbesondere zehn Nadelimpulsen pro Spannungssignal genutzt werden. Damit liegt die Zeit in der beispielweise bei Verwendung eines Rechteckimpulses die volle Pulsspannung angelegt werden kann bei zumindest drei, fünf bzw. 10 Mikrosekunden, bevorzugt bei zumindest sechs, fünzehn bzw. dreissig Mikrosekunden. Die Höchstdauer kann bei zeitlich Taktung beispielsweise mit der halben Frequenz des Spannungssignals festgelegt werden.

Ähnlich lassen sich auch mit einer Spannungsversorgung, wie beispielsweise in WO 06099759 beschrieben, sehr steile, gut definierte Spannungssignale realisieren, die auch aus einem Paket aufeinander folgender Nadelimpulse zusammengesetzt sein können, um eine entsprechende Erhöhung der Funkenentladespannung zu bewirken.

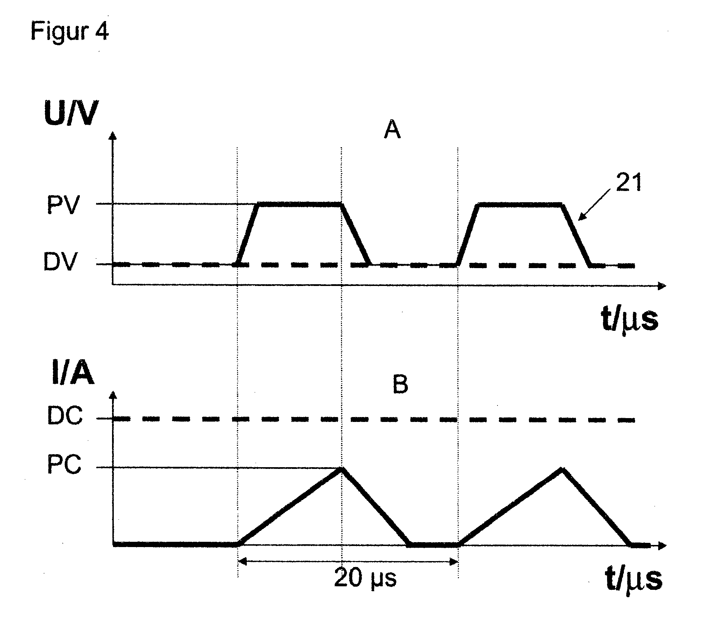

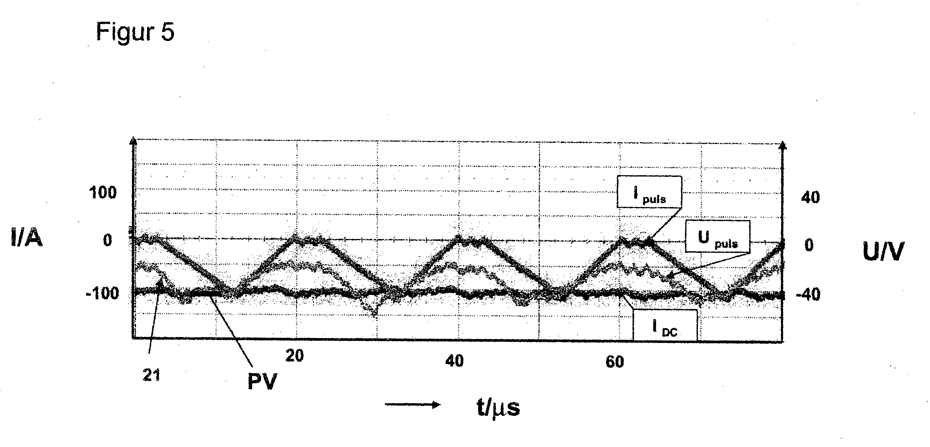

In Figur 4 ist das prinzipielle Spannungs/Strom-Verhalten für die Wirkungsweise solcher parallel geschalteter, gepulster Spannungsquellen angegeben. Figur 4 A zeigt in Analogie zu Figur 3, ohne nähere Details zur Erzeugung der Resultierenden 21, den durch die DC-Stromversorgung 13 (gestrichelte Linie) und die Pulsspannungsquelle 15, bzw. 18 bis 20 (durchgezogene Linie) resultierenden Spannungsverlauf der Funkenspannung. Figur 4 B zeigt den entsprechenden Stromverlauf. Dabei erfolgt der Stromanstieg des Funkenstroms praktisch unmittelbar bei Anlegen des Pulssignals der Höhe PV durch die gepulste Spannungsquelle und erhöht damit den durch das Funkenentladungsplasmsa fliessenden Entladungsstrom. Hier sei bemerkt, dass in den Figuren 4 und 5 nicht die Summenkurve des Entladestroms, sondern die Kurven der von der gepulsten Spannungsquelle (durchgezogene Linie) bzw. der DC-Stromversorgung 13 (strichlierte Linie) erzeugten Ströme getrennt dargestellt sind. Während die Funkenspannung sehr rasch den Sollwert erreicht, der über die Länge des Pulses praktisch stationär gehalten werden kann, wächst der Funkenstrom quasi linear über die gesamte Pulsdauer mit einer deutlich geringeren Steigung, die durch Kabelimpedanzen und andere Widerstände des Funkenstromkreises bestimmt ist. Der Funkenstrom geht dabei nicht in Sättigung, wie es auch entsprechend des Townsenddiagramms zu erwarten ist. Erst das Abschalten des Spannungspulses und der Abfall der Funkenentladespannung lässt den Funkenstrom wieder sinken. Prinzipiell können also mit gepulsten Spannungsquellen, die parallel zu DC-Funkenstromversorgung geschaltet werden, quasistationäre Spannungserhöhungen der Funkenentladespannung erzielt werden. Die Steilheit und der Wert der Spannungsüberhöhung im Pulsbetrieb hängt dabei von verschiedenen Parametern wie zum Beispiel der Kabelimpedanzen, Entladungsimpedanz, Targetmaterial etc. ab. Die Steilheit des Pulses und die Amplitude der Spannungserhöhung beeinflussen sich auch gegenseitig. Je steiler der Spannungspuls gestaltet werden kann, umso grösser ist die mögliche Spannungsüberhöhung auf Grund der relativen Trägheit des Stromanstiegs. Allerdings wird aus der Abbildung 4 auch verständlich, dass die Pulslänge nicht unbegrenzt lang sein kann, da die Spannungsüberhöhung zum Nachführen des Funkenstroms führt, was üblicherweise bei Erreichen eines Schwellenwerts, auch Kurzschlussstrom genannt, zum automatischen Abschalten der Spannungsversorgung führt. Auch dieser automatische Abschaltpunkt kann neben der Begrenzung über die Pulslänge Tp des Spannungssignals, der Länge Tₙ bzw. der Abfolge und Anordnung der Nadelimpulse, dazu benutzt werden, um den Stromanstieg und die damit verbundenen Verdampfungsprozesse auf der Funkenkathode zu steuern.

Figur 5 zeigt eine während eines wie unten näher angegebenen Pulsbeschichtungsprozesses aufgenommene Stromspannungskurve mit dem von einer Pulsspannungsversorgung 15 periodisch angelegtem Spannungssignal Uₚᵤₗₛ und entsprechendem Pulsstrom Iₚᵤₗₛ der dem Gleichstrom I_{DC} aus der DC-Stromversorgung 13 überlagert wird. Auch hier ist erkennbar, dass der Pulsstrom Iₚᵤₗₛ auch nach dem Erreichen der Pulsspannung PV solange ansteigt, bis der Puls abgeschaltet wird. Die Spannungsüberhöhung gegenüber dem DC-Betrieb liegt in diesem Fall bei ca. -20 V.

Die gezeigten Stromspannungskurven wurden bei der Abscheidung von Al₂O₃ bzw. (Al,Cr)₂O₃-Schichten in einem Innova Produktionssystem der Firma Oerlikon Balzers unter folgenden Bedingungen vorgenommen:
1. Prozessparameter für die Funkenverdampfung zur Herstellung von Aluminiumoxid:

| | |
|---|---|
| Sauerstofffluss | 400 sccm |
| Prozessdruck | 1x10⁻² mbar |
| DC Quellenstrom Al-Target | 100 A |
| Puls-Quellenstrom Al-Target | 100 A bei 50 kHz, 10µs Puls/10 µs Pause |
| Substratbias | -40 V |
| | DC gepulst oder AC (jeweils-50-350 kHz) |
| Substrattemperatur | ca. 500°C |
| Prozesszeit | 60 bis 120 min, ein zelne Versuche mit 360 min. |

Die Anstiegszeit der ansteigenden Flanke 23 der Resultierenden des Spannungspulses wurde dabei zu etwa 6 V/µs gemessen.
2. Prozessparameter für die Funkenverdampfung zur Herstellung von Aluminium/Chromoxid-Mischkristallen in Korundstruktur:

| | |
|---|---|
| Sauerstofffluss | 1000 sccm |
| Prozessdruck | 2.6x10⁻² mbar |
| DC Quellenstrom Al_{0.7}Cr_{0.3}: | 120 A |
| Puls-Quellenstrom Al_{0.7}Cr_{0.3}: | 100 A, 30 kHz, 8 µs Puls/25 µsPause. |

Der Spulenstrom des Quellen-Magnetfeldes, Typ Oerlikon Balzers MAG 6, wurde mit 0.5 A eingestellt. Damit wurde an der Targetoberfläche ein im Wesentlichen senkrechtes schwaches Feld von ca. 2 mT (20 Gs) erzeugt.

| | |
|---|---|
| Substratbias | U = -60 V (bipolar, 36 µs negativ, 4 µs positiv) |
| Substrattemperatur | ca. 550° C |
| Prozesszeit | 60 bis 120 min |

Die Anstiegszeit der ansteigenden Flanke 23 der Resultierenden des Spannungspulses wurde dabei zu etwa 2 V/µs gemessen.

Durch entsprechende Anpassung der Pulsspannungsversorgung, beispielsweise durch die Wahl sehr kurzer Kabelverbindungen zu den Funkenquellen, konnten Steilheiten bis 100 V/µs erzielt werden.

### Bezugszeichenliste

- 1: Funkenbeschichtungsanlage
- 2: Vakuumpumpstand
- 3: Substrathalterung
- 4: Pulsbiasversorgung
- 5: Target
- 6: Anode
- 7: Zündvorrichtung
- 8: Ionisationskammer
- 9: Filament
- 10: Hilfsanode
- 11: Gaseinlass
- 12: Targetmagnetsystem
- 13: DC-Stromversorgung
- 14: Masseschalter
- 15: Pulsspannungsversorgung
- 16: Generatoreinheit
- 17: Spule
- 18: Ladespannungsversorgung
- 19: Kondensator
- 20: Pulsschalter
- 21: Resultierende
- 22: Nadelimpuls
- 23: ansteigende Flanke

## Patentansprüche

1. Verfahren zum Betreiben einer Arcquelle, wobei eine elektrische Funkenentladung auf einer Oberfläche eines Targets (5) gezündet bzw. betrieben wird, und die Funkenentladung gleichzeitig mit einem Gleichstrom, dem eine Gleichspannung (DV) zugeordnet ist, als auch mit einem periodisch angelegten Pulsstrom gespiesen wird, **dadurch gekennzeichnet, dass** ein gepulstes Spannungssignal (21) mit einer Pulsspannung (PV) und einer Pulslänge (Tₚ) von mehreren Mikrosekunden erzeugt wird und sich der Pulsstrom aus dem gepulsten Spannungssignal (21) ergibt.

2. Verfahren nach Anspruch 1, weiter **dadurch gekennzeichnet, dass** die Signalform des Spannungssignals im Wesentlichen frei wählbar ist.

3. Verfahren nach einem der vorhergehenden Ansprüche, weiter **dadurch gekennzeichnet, dass** die Frequenz des Spannungssignals zwischen 1 Hz und 200 kHz, bevorzugt zwischen 10 Hz und 50 kHz liegt.

4. Verfahren nach einem der vorhergehenden Ansprüche, weiter **dadurch gekennzeichnet, dass** die Signalform ein Sägezahn, ein Vieleck, ein Trapez, bevorzugt aber ein Rechteck ist.

5. Verfahren nach einem der vorhergehenden Ansprüche, weiter **dadurch gekennzeichnet, dass** das Spannungssignal im lückenden Betrieb angelegt wird.

6. Verfahren nach einem der vorhergehenden Ansprüche, weiter **dadurch gekennzeichnet, dass** das Spannungssignal bei Überschreitung einer detektierten Stromschwelle abgeschaltet wird.

7. Verfahren nach einem der vorhergehenden Ansprüche, weiter **dadurch gekennzeichnet, dass** die Signalform des Spannungssignals (21) durch die Resultierende (21) einer Aneinanderreihung von Nadelimpulsen (22) gebildet wird.

8. Verfahren nach Anspruch 7, weiter **dadurch gekennzeichnet, dass** die Nadelimpulse (22) durch eine in zeitlicher Abfolge gesteuerte Entladung einzelner Kondensatoren (19) oder durch eine Pulsspannungsversorgung (15) erzeugt werden.

9. Verfahren nach einem der Ansprüche 7 oder 8, weiter **dadurch gekennzeichnet, dass** die Flankensteilheit der ansteigende Flanke (23) der Nadelimpulse (22) zumindest 0.5 V/µs, bevorzugt aber zumindest 2 V/µs beträgt.

10. Verfahren nach einem der Ansprüche 7 bis 9, weiter **dadurch gekennzeichnet, dass** die Abfolge bzw. die Dauer der Nadelimpulse (22) zwischen 0.1 kHz und 1 MHz bzw. 10 ms und 1 µs, bevorzugt zwischen 1 kHz und 500 kHz bzw. 1 ms und 2 µs liegt.

11. Verfahren nach einem der Ansprüche 7 bis 10, weiter **dadurch gekennzeichnet, dass** die Höhe des Nadelimpulses (22) die anliegende Gleichspannung DV um mindestens 10 Prozent, bevorzugt um mindestens 30 Prozent übersteigt.

12. Verfahren nach einem der Ansprüche 7 bis 11, weiter **dadurch gekennzeichnet, dass** zumindest 3, bevorzugt zumindest 5 Nadelimpulse (22) zur Erzeugung des Spannungssignals verwendet werden.

13. Verfahren nach einem der vorhergehenden Ansprüche, weiter **dadurch gekennzeichnet, dass** das Spannungssignal durch eine in Bezug auf Signallänge, Signalfrequenz, Spannungsamplitude, Pulspausen und/oder Signalform frei einstellbare Pulsspannungsversorgung (15) bzw.Generatoreinheit (16) bereitgestellt wird.

14. Verfahren nach einem der Ansprüche 7 bis 12, weiter **dadurch gekennzeichnet, dass** das Spannungssignal durch eine in Bezug auf die zeitliche Abfolge, die Flankensteilheit und/oder die Höhe der Nadelimpulse frei einstellbare Pulsspannungsversorgung (15) bzw. Generatoreinheit (16) bereitgestellt wird.

15. Verfahren nach einem der vorhergehenden Ansprüche, weiter **dadurch gekennzeichnet, dass** die Steilheit der ansteigende Flanke (23) des Spannungssignals zumindest 0.5 V/µs, bevorzugt aber zumindest 2 V/µs beträgt.

16. Verfahren nach einem der vorhergehenden Ansprüche, weiter **dadurch gekennzeichnet, dass** im Wesentlichen über die gesamte Pulslänge (Tₚ) die bevorzugt konstante Pulsspannung (PV) angelegt wird.

17. Verfahren nach einem der vorhergehenden Ansprüche, weiter **dadurch gekennzeichnet, dass** das periodisch angelegte Spannungssignal alternierend an Targets (5) mehrerer Arcquellen angelegt wird.

18. Verfahren zur Herstellung beschichteter Substrate mittels einer nach dem Verfahren gemäss einem der Ansprüche 1 - 17 betriebenen Arcquelle.

19. Verfahren nach Anspruch 18, **dadurch gekennzeichnet, dass** isolierende, insbesondere oxidhaltige oder oxidische Schichten abgeschieden werden.

20. Verfahren nach einem der vorhergehenden Ansprüche 18 oder 19, weiter **dadurch gekennzeichnet, dass** das Material des Targets (5) der Arcquelle aus Kohlenstoff oder aus einem Material mit mehr als 20 vol% Kohlenstoff besteht.

## Claims

1. Method for operating an arc source, whereby an electric spark discharge is ignited respectively run on a surface of a target (5) and the spark discharge is simultaneously fed a direct current with an associated constant voltage DV as well as a periodically applied pulsed current,
**characterized in that** a pulsed voltage signal (21) is generated and the pulsed current results from the pulsed voltage signal (21) and that the pulsed voltage signal (21) is generated with a pulse length (Tₚ) of several microseconds.

2. Method according to claim 1, **characterized in that** the shape of the voltage signal is substantially arbitrarily selectable.

3. Method according to one of the previous claims, **characterized in that** the frequency of the voltage signal is between 1 Hz and 200 kHz, preferably between 10 Hz and 50 kHz.

4. Method according to one of the previous claims, **characterized in that** the shape of the signal is in the form of a sawtooth, a polygon, a trapezoid or a rectangle.

5. Method according to one of the previous claims, **characterized in that** the voltage signal is applied in gapped succession.

6. Method according to one of the previous claims, **characterized in that** the voltage signal is turned off when a detected current threshold is exceeded.

7. Method according one of the previous claims, **characterized in that** the shape of the signal is constituted of the resultant (21) of a succession of spike pulses (22).

8. Method according to claim 7, **characterized in that** the spike pulses (22) are generated by a time-controlled sequence of discharges of individual capacitors (19) or by a pulsed power supply (15).

9. Method according to one of claims 7 and 8, **characterized in that** the edge steepness of the ascending slope (23) of the spike pulses (22) is at least 0.5 V/µs, preferably at least 2 V/µs.

10. Method according to one of claims 7 to 9, **characterized in that** the succession respectively the duration of the spike pulses (22) is between 0.1 kHz and 1 MHz respectively between 10 ms and 1 µs, preferably between 1 kHz and 500 kHz respectively between 1 ms and 2 µs.

11. Method according to one of claims 7 to 10, **characterized in that** a height PV of the spike pulses (22) exceeds the applied direct current voltage DV by at least 10 percent, preferably by at least 30 percent.

12. Method according to one of claims 7 to 11, **characterized in that** at least 3, preferably at least 5, spike pulses (22) are used for generating the voltage signal.

13. Method according to one of the previous claims, **characterized in that** the voltage signal is provided by a pulsed voltage supply (15) respectively generator unit (16) that is arbitrarily adjustable with regard to signal length, signal frequency, voltage amplitude, interpulse periods and/or shape of the signal.

14. Method according to one of the previous claims, **characterized in that** the voltage signal is provided by a pulsed voltage supply (15) respectively generator unit (16) that is arbitrarily adjustable with regard to the timed sequence, slope angle and/or height of the spike pulses (22).

15. Method according to one of the previous claims, **characterized in that** the steepness of the ascending slope (23) of the voltage signal is at least 0.5 V/µs, preferably at least 2 V/µs.

16. Method according to one of the previous claims, **characterized in that** the preferred constant pulsed voltage PV is applied substantially over the entire pulse length Tₚ.

17. Method according to one of the previous claims, **characterized in that** the periodically applied voltage signal is alternatingly applied to the targets (5) of several arc sources.

18. Method according to one of the previous claims, **characterized in that** insulating, in particular oxide-containing or oxidic layers are deposited.

19. Method according to one of the previous claims, **characterized in that** the material of the target (5) consists of carbon or of a material containing more than 20 vol% carbon by volume.

20. Method for manufacturing coated substrates by means of a method for operating an arc source according to one of the claim 1 - 19.

## Revendications

1. Procédé pour le fonctionnement d'une source d'arc, étant précisé qu'une décharge électrique à étincelles est amorcée ou déclenchée sur une surface d'une cible (5) et que la décharge à étincelles est alimentée en même temps avec un courant continu, auquel est associée une tension continue (DV), et avec un courant pulsé appliqué périodiquement, **caractérisé en ce qu'**un signal de tension pulsé (21) est généré avec une tension pulsée (PV) et une longueur d'impulsion (Tₚ) de plusieurs microsecondes, et le courant pulsé résulte du signal de tension (21).

2. Procédé selon la revendication 1, également **caractérisé en ce que** la forme du signal de tension peut dans l'ensemble être choisie librement.

3. Procédé selon l'une des revendications précédentes, également **caractérisé en ce que** la fréquence du signal de tension est située entre 1 Hz et 200 kHz, de préférence entre 10 Hz et 50 kHz.

4. Procédé selon l'une des revendications précédentes, également **caractérisé en ce que** la forme de signal est en dent de scie, polygonale, trapézoïdale, mais de préférence rectangulaire.

5. Procédé selon l'une des revendications précédentes, également **caractérisé en ce que** le signal de tension est appliqué de manière discontinue.

6. Procédé selon l'une des revendications précédentes, également **caractérisé en ce que** le signal de tension est arrêté si un seuil de courant détecté est dépassé.

7. Procédé selon l'une des revendications précédentes, également **caractérisé en ce que** la forme du signal de tension (21) est formée par la résultante (21) d'un alignement d'impulsions en pointe (22).

8. Procédé selon la revendication 7, également **caractérisé en ce que** les impulsions en pointe (22) sont générées par une décharge de condenseurs individuels (19) commandée successivement dans le temps, ou par une alimentation en tension pulsée (15).

9. Procédé selon l'une des revendications 7 ou 8, également **caractérisé en ce que** la pente du flanc montant (23) des impulsions en pointe (22) est d'au moins 0,5 V/µs, mais de préférence d'au moins 2 V/µs.

10. Procédé selon l'une des revendications 7 à 9, également **caractérisé en ce que** la succession ou la durée des impulsions en pointe (22) est située entre 0,1 kHz et 1 MHz ou 10 ms et 1 µs, de préférence entre 1 kHz et 500 kHz ou 1 ms et 2 µs.

11. Procédé selon l'une des revendications 7 à 10, également **caractérisé en ce que** la hauteur de l'impulsion en pointe (22) dépasse d'au moins 10 pour cent, de préférence d'au moins 30 pour cent, la tension continue DV appliquée.

12. Procédé selon l'une des revendications 7 à 11, également **caractérisé en ce qu'**au moins 3, de préférence au moins 5 impulsions en pointe (22) sont utilisées pour produire le signal de tension.

13. Procédé selon l'une des revendications précédentes, également **caractérisé en ce que** le signal de tension est fourni par une alimentation en tension pulsée (15) ou une unité génératrice (16) dont la longueur de signal, la fréquence de signal, l'amplitude de tension, les pauses d'impulsions et/ou la forme de signal sont librement réglables.

14. Procédé selon l'une des revendications 7 à 12, également **caractérisé en ce que** le signal de tension est fourni par une alimentation en tension pulsée (15) ou une unité génératrice (16) dont la succession dans le temps, la pente de flanc et/ou la hauteur des impulsions en pointe sont librement réglables.

15. Procédé selon l'une des revendications précédentes, également **caractérisé en ce que** la pente du flanc montant (23) du signal de tension est d'au moins 0,5 V/µs, mais de préférence d'au moins 2 V/µs.

16. Procédé selon l'une des revendications précédentes, également **caractérisé en ce que** la tension pulsée (PV) de préférence constante est appliquée globalement sur toute la longueur d'impulsion (Tp).

17. Procédé selon l'une des revendications précédentes, également **caractérisé en ce que** le signal de tension appliqué périodiquement est appliqué en alternance aux cibles (5) de plusieurs sources d'arc.

18. Procédé pour fabriquer des substrats revêtus, à l'aide d'une source d'arc fonctionnant suivant le procédé selon l'une des revendications 1 à 7.

19. Procédé selon la revendication 18, également **caractérisé en ce que** des couches isolantes, en particulier contenant des oxydes ou oxydiques, sont déposées.

20. Procédé selon l'une des revendications 18 ou 19 précédentes, également **caractérisé en ce que** le matériau de la cible (5) de la source d'arc se compose de carbone ou d'un matériau avec plus de 20 % en volume de carbone.
